# EUROPEAN PATENT SPECIFICATION

(11) **EP 1 162 635 B1**
(45) Date of publication and mention of the grant of the patent: **01.09.2004**
(21) Application number: 01113802.1
(22) Date of filing: 06.06.2001
(51) Int. Cl.: H01F 10/24, H01F 41/28

(54) **Material for bismuth substituted garnet thick film and a manufacturing method thereof**
Material für mit Wismut substituierte Granat-Dickschicht und zugehöriges Herstellungsverfahren
Matériau pour film épais de grenat substitué par du bismuth et procédé de fabrication

(30) Priority: 06.06.2000 JP 2000169308
(43) Date of publication of application: 12.12.2001
(73) Proprietor: NEC TOKIN Corporation, Sendai-shi, Miyagi (JP)
(72) Inventor: Sato, Tadakuni, Sendai-shi, Miyagi (JP); Endo, Kazumitsu, Sendai-shi, Miyagi (JP)
(74) Representative: Prüfer, Lutz H., Dipl.-Phys.

(56) References cited:
- DE-A- 2 318 798
- GB-A- 1 441 353
- PATENT ABSTRACTS OF JAPAN vol. 1999, no. 13, 30 November 1999 (1999-11-30) & JP 11 236297 A (TOKIN CORP), 31 August 1999 (1999-08-31)

## Description

### BACKGROUND OF THE INVENTION

### 1. Field of the Invention

This invention relates to a bismuth (Bi) substituted garnet among optical garnet materials having a Faraday rotation effect and a manufacturing method thereof and, more specifically, to a single crystal thick film of GdBi series garnet grown by a liquid phase growing method and a manufacturing method thereof.

### 2. Statement of Related Art

Heretofore, devices based on the Faraday rotation effect have been developed and put into practical use in the light communication or optical information processing. In light communication apparatus using semiconductor laser oscillators, when reflection light from optical fiber cables or connectors return to laser oscillation portions, noises increase to make the oscillators. Therefore, an optical isolator utilizing the Faraday rotation effect has been used in order to ensure oscillation the state by shutting return light.

Bi substituted type rare earth garnets having a large Faraday rotation effect been grown by an LEP method, flux method or the like and used for isolators in near infrared regions.

Particularly, since garnet thick films grown by the LPE method are excellent in productivity, most of the garnet thick films have been produced by this method at present.

At present, in communication systems using optical fiber cables, wavelength bands from 1.31 µm to 1.55 µm and, further, from 1.6 to 2 µm have been utilized.

As the material for Faraday rotation devices for near infrared regions used in such wavelength bands, TbBi series garnet thick films and GdBi series (Ga or Al-substituted) garnet thick films prepared by the LPE method have been marketed.

The former material has a small temperature variation coefficient of the Faraday rotation per 45 deg as about 0.04 to 0.06 deg/°C but the application magnetic field intensity Hs is as high as about 6.3662·10⁴ to 9.5493·10⁴ A/m (800 to 1200 Oe) to require a powerful permanent magnet. The material has a magnetization inversion temperature of about -50°C or lower and can be used in a wide temperature range.

On the other hand, the latter material has a large temperature variation coefficient of the Faraday rotation per 45 deg as about 0.08 deg/°C, Hs is as small as about 2.3873·10⁴ A/m (300 Oe), the magnetization inversion temperature is as high as about -10°C and the working temperature range is near the life environmental temperature.

Accordingly, market's demand has been increased for TbBi series garnet materials having satisfactory temperature characteristics.

However, for rare earth Bi series garnet materials, absorption spectrum attributable to Tb ions appears in a region of a wavelength of 1.6 µm or longer, as shown in the chart of a literature entitled as "Effect of Impurities on the Optical Properties of Yttrium Iron Garnet" in the Journal of Applied Physics, vol. 38, No. 3, pp. 1038, and increase of transmission loss in this wavelength region is inevitable in the TbBi garnet material.

On the other hand, for GdBi series (Ga, Al-substituted) garnet thick film, the manufacturing conditions are shown in the literature entitled as "LPE Growth of Bismuth Substituted Gadolinium Iron Garnet Layers: Systematization of Experimental Result" in the Journal of Crystal Growth 64 (1983), p. 275, but the literature does not suggest the GdBi series (Yb, Al-substituted) garnet thick film.

It is desirable that the optical isolator shows higher transmittance in the advancing direction and lower transmittance in the direction opposite thereto.

### SUMMARY OF THE INVENTION

In view of the above, it is an object of this invention to provide a material for bismuth-substituted garnet thick film capable of avoiding light absorption at a wavelength of about 1.6 µm inherent to the TbBi series garnet and improving the temperature variation coefficient of the Faraday rotation effect of the GdBi series garnet, as well as a manufacturing method thereof.

It is another object of this invention to reduce the cost by using commercially available substituted gadolinium-gallium-garnet (SGGG) substrate of a large grown substrate diameter

It is still another object of this invention to provide a Faraday rotation device used in a wavelength region in excess of about 1.5 µm.

According to one aspect of this invention, there is provided a material for a bismuth substituted garnet thick film which comprises Gd, Yb, Bi, Fe and Al as the main ingredient grown by a liquid phase growing method on a garnet substrate in which the composition of the garnet thick film is represented by the general formula:

Gd_{3-x-y}YbₓBi_{y}Fe_{5-z}Al_{z}O₁₂

(0 < x ≤ 0.5, 0.85 ≤ y ≤ 1.55 and 0.15 ≤ z ≤ 0.65), and each of boron oxide (B₂O₃) and lead oxide (PbO) is contained by from 0 to 4.0 wt% (not including 0) in the garnet thick film.

According to another aspect of this invention, there is provided a Faraday rotation device which comprises substantially a garnet thick film comprising Gd, Yb, Bi, Fe and Al as the main ingredient grown by a liquid phase growing method on a garnet substrate. In the Faraday reotation device, the composition of the garnet thick film is represented by the general formula:

Gd_{3-x-y}YbₓBi_{y}Fe_{5-z}Al_{z}O₁₂

(0 < x ≤ 0.5, 0.85 ≤ y ≤ 1.55 and 0.15 ≤ z ≤ 0.65), and each of boron oxide (B₂O₃) and lead oxide (PbO) is contained by from 0 to 4.0 wt% (not including 0) in the garnet thick film.

According to still another aspect of this invention, there is provided a method of manufacturing a material for bismuth substituted garnet thick film of growing a garnet thick film comprising Gd, Yb, Bi, Fe and Al by a liquid phase growing method on a garnet substrate. In the present invention, the method includes growing the garnet thick film on a substituted gadolinium - gallium - garnet (SGGG) substrate and the composition of the garnet thick film is represented by the general formula:

Gd_{3-x-y}YbₓBi_{y}Fe_{5-z}Al_{z}O₁₂

(0 < x ≤ 0.5, 0.85 ≤ y ≤ 1.55 and 0.15 ≤ z ≤ 0.65), and each of boron oxide (B₂O₃) and lead oxide (PbO) is contained by from 0 to 4.0 wt% (not including 0) in the garnet thick film.

### BRIEF DESCRIPTION OF THE DRAWING

Fig. 1 is a graph showing a relation between a B₂O₃ content and an insertion loss (I. L.) in a GdBi series garnet thick film in a first example according to this invention;
Fig. 2 is a graph showing a relation between a PbO content and an insertion loss (I. L.) in a GdBi series garnet thick film in a second example according to this invention;
Fig. 3 is a graph showing a relation between a heat treatment temperature and an insertion loss (I. L.) in a GdBi series garnet thick film in a third example according to this invention;
Fig. 4 is a graph showing a relation between an oxygen concentration in a heat treatment atmosphere and an insertion loss (I. L.) in a GdBi series garnet thick film in a fourth example according to this invention;
Fig. 5A is a graph showing a relation between θ_{F/T} and z for the dependence of the optical and magnetic characteristics on the composition z in a GdBi series garnet thick film of a fifth example according to this invention;
Fig. 5B is a graph showing a relation between Hs and z for the dependence of the optical and magnetic characteristics on the composition z in a GdBi series garnet thick film of a fifth example according to this invention;
Fig. 6 is a graph showing a relation between a composition x and Hs in a GdBi series garnet thick film of a sixth example according to this invention;
Fig. 7A is a graph showing a relation between θ_{F/T} and y for the dependence of the optical and magnetic characteristics on the composition y in a GdBi series garnet thick film of a seventh example according to this invention; and
Fig. 7B is a graph showing a relation between Hs and z for the dependence of the optical and magnetic characteristics on the composition y in a GdBi series garnet thick film of a seventh example according to this invention.

### DESCRIPTION OF PREFERRED EMBODIMENTS

Prior to the description of examples according to this invention, principle of the invention will be explained.

The demand for specific characteristics of the GdBi series garnet includes that
(1) the material exhibits high transmittance (low insertion loss) in a wavelength region in excess of 1.5 µm,
(2) the average variation coefficient θ_{F/T} of the Faraday rotation within a temperature range of -20°C - +80°C per 45 deg shows a better value than that of marketed GdBi series garnet materials (about 0.08 deg/°C),
(3) the magnetization inversion temperature T_{comp} is -20°C or lower (usable in usual life environmental temperature range) (in this example, since measurement for T_{comp} is difficult at -40°C or lower, the lower temperature is indicated as -40°C or lower) and, further,
(4) the insertion loss (I. L.) at a thickness where the Faraday rotation angle is about 45 deg is 0.2 dB or less (usually may be 0.3 dB or less) and
(5) the required minimum application magnetic field to reach the saturated state (required magnetic field Hs) is 3.9789·10⁴ A/m (500 Oe) or less (enabling the use of the small permanent magnet, which is useful for reducing the cost and minimizing the scale). They are defined as the adaptible range of the garnet material in this invention.

For the Faraday rotation device, larger Faraday rotation effect θ_{F} (Faraday rotation angle per unit thickness) can reduce the film thickness of the device. In the LPE method, industrial disadvantages are often caused such as deterioration of crystallinity and increase in the occurrence of cracks as the thickness of the grown film increases.

Accordingly, it is desirable that the Faraday rotation effect θ_{F} can be made larger.

The Faraday effect θ_{F} of the marketed GdBi series garnet thick films at a wavelength of 1.55 µm is about 800 deg/cm.

Also in this invention, it is desirable that the Faraday rotation effect θ_{F} has an equivalent or larger value. The Faraday rotation effect θ_{F} can not easily be changed by the change of the simple factors but optimized and attained by the adaptation of various solution or melt compositions and growing conditions.

As a result, the material capable of satisfying the requirements (1) - (5) described above can be obtained to accomplish the present invention by growing a garnet thick film comprising Gd, Yb, Bi, Fe and Al as the main ingredient and containing each of B₂O₃ and PbO by 0 to 4.0 wt% (not including 0) by an LPE method, growing the garnet on an SGGG, substituted type gadolinium-gallium-garnet, substrate and subjecting the garnet thick film to a heat treatment in an atmosphere of 10 to 100% oxygen content at a temperature from 950 to 1140°C.

The reasons for defining each of the compositions and various conditions in this invention are to be explained.

In the material for the garnet thick film, the content for each of B₂O₃ and PbO is defined as 0 to 4.0 wt% (not including 0) because it has been found that the insertion loss (I. L.) is decreased at the content within the range described above. The effect of reducing the insertion loss by the incorporation of B₂O₃ and PbO is supposed to be an effect of conditioning the ionic state of crystal constituent elements in the garnet composition.

By the way in the LPE method, it is desirable that the lattice constant of the substrate and the lattice constant of the garnet thick film are close to each other. Accordingly, an SGGG substrate of lattice constant: about 1.2496 nm (12.496 Å) is used for the TbBi series garnet and an NGG substrate of lattice constant: about 1.2509 nm (12.509 Å) is used for the GdBi series garnet.

However, the maximum diameter of the marketed NGG substrate is 5.08 cm (2 inch).

On the other hand, SGGG substrates of 7.62 cm (3 inch) diameter are marketed.

Accordingly, if it can be grown in the GdBi series garnet SGGG substrate, remarkable reduction of the cost and increase in the production amount can be attained.

Further, in the method of manufacturing the material for the garnet thick film according to this invention, the material for the garnet thick film is heat treated within a range from 950 to 1140°C, because reduction of the insertion loss (I. L.) is recognized within the range, and the homogenization of the composition is insufficient due to low temperature if it is lower than 950°C, while garnet decomposition (evaporation of Bi₂O₃) is caused if it exceeds 1140°C.

The reduction of the insertion loss (I. L.) by the heat treatment is attributable to the improvement of homogenization due to diffusion of atoms, i.e. reduction of scattering in the crystal lattice and ion balance.

Further, in the method of manufacturing the material for the garnet thick film according to this invention, the oxygen content in the atmosphere upon heat treatment is 10% or more, because the effect, such as reduction of the insertion loss, is recognized by the heat treatment at such content, while loss of insertion (I. L.) increases at the content of less than 10% due to the insufficiency of oxygen in the garnet.

Change of the characteristics by the compositional value of the main ingredient in the material for the garnet thick film according to this invention has a close concern with the substitution of atoms in the crystal lattice and the magnetic spin and the compositional range in this invention gives an optimum region for the optical characteristics.

The liquid phase growing method (LPE method) for the Bi-substituted garnet for use in the Faraday rotation device used, for example, in optical isolators is conducted as described below.

Garnet ingredients, Gd₂O₃, Yb₂O₃, Fe₂O₃, Al₂O₃, etc, are melted using PbO, Bi₂O₃, B₂O₃ or the like as the flux ingredient at bout 900 to 1100°C in a platinum crucible to prepare a solution or melt, and then temperature is lowered to attain a super cooled state, i.e. state of super saturated solution. A garnet substrate is immersed in the melt and rotated for a long period of time to grow a thick film of Bi-substituted garnet.

Among the Bi substituted garnets grown as described above, the GdBi series garnet has a feature of having a relatively high Faraday rotation effect θ_{F} and that the required magnetic field applied to garnet may be small. The necessary application magnetic field, i.e. required magnetic field Hs, is a magnetic field necessary to reach the minimized the insertion loss of garnet. Physically, this is a magnetic field necessary for aligning the magnetic spins of garnet in one direction.

Generally, the applied magnetic field is adapted to be supplied from a permanent magnet disposed at the periphery of a garnet film. Accordingly, if the saturation magnetization 4 π Ms of the garnet film is low, Hs is also lowered and the characteristics of the magnet used can be lowered. At the same time, it is possible to reduce the size the weight, which is industrially useful.

Then, examples of this invention are to be explained with reference to the drawings.

### (First Example)

GdBi series garnet films each of a composition comprising about 0.5 wt% of PbO, with the main ingredient ratio of Gd_{1.4}Yb_{0.3}Bi_{1.3}Fe_{4.4}Al_{0.6}O₁₂ and containing B₂O₃ by 0, 1, 2, 3, 4 and 5 wt% were grown to a thickness of about 500 µm using powders of gadolinium oxide (Gd₂O₃), ytterbium oxide (Yb₂O₃), ferric oxide (Fe₂O₃), aluminum oxide (Al₂O₃), bismuth oxide (Bi₂O₃), lead oxide (PbO) and boron oxide (B₂O₃) at high purity as the starting material and using a PbO-Bi₂O₃-B₂O₃ system flux by the LPE method on an SGGG substrate of lattice constant, about 1.2496 nm (12.496 Å).

Then, the substrates for the specimens were removed, both surfaces were polished to such a thickness that the Faraday rotation angle at a wavelength of 1.55 µm was about 45 deg.

The composition described above was determined as an average value of EPMA analysis conducted for both surfaces of these specimens each at five points. It was determined for B₂O₃ by conducting atomic absorption analysis to the specimen.

Then, after applying non-reflection coating of an SiO₂ film on the specimen plates, a magnetic field was applied up to about 3.9789·10⁴ A/m (0.5 kOe) by using an electromagnet to determine the minimum application magnetic field at which the permeability reaches saturation, i.e. required magnetic field Hs, insertion loss (I. L.), the Faraday rotation effect θ_{F} and the temperature variation coefficient θ_{F/T} of the Faraday rotation per 45 deg (θ_{F/T}) at -20°C to +80°C.

As a result, Hs was about 3.1831·10⁴ A/m (400 Oe), θ_{F} was about 1200 deg/cm, θ_{F/T} was about 0.06 deg/°C and T_{comp} was -40°C or lower for all specimens.

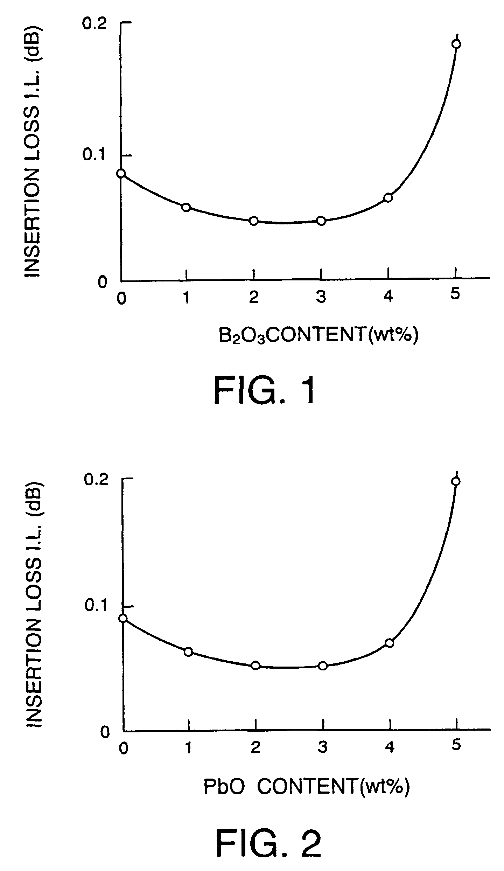

The relation between the insertion loss (I. L.) and the B₂O₃ content is as shown in Fig. 1.

As can be seen from Fig. 1, while the insertion loss (I. L.) decreases by the incorporation of B₂O₃ but it remarkably increase in a region in excess of 4.0 wt%. From the foregoings, the range from 0 to 4.0 wt% (not including 0) is effective for the reducing effect of the insertion loss (I. L.). A range from 1 to 3.2 wt% is particularly preferred.

### (Second Example)

In the same manner as in the first example, after growing GdBi series garnet films each of a composition containing B₂O₃ by about 0.5 wt%, having an ingredient ratio of Gd_{1.7}Yb_{0.2}Bi_{1.1}Fe_{4.6}Al_{0.4}O₁₂ and containing 0, 1, 2, 3, 4 and 5 wt% of PbO to a thickness of about 600 µm, specimens were prepared and characteristics were measured.

As a result, Hs was about 400 Oe, θ_{F} was about 1100 deg/cm, θ_{F/T} was about 0.06 deg/°C and T_{comp} was -40°C or lower for all specimens.

As can be seen from Fig. 2, the insertion loss (I. L.) is decreased by the incorporation of PbO and it remarkably increases in a region in excess of 4.0 wt% of PbO.

Accordingly, a range for PbO content from 0 to 4.0 wt% (not including 0) can be said to be useful. More preferably, by making the PbO content within a range from 0.4 to 4.0 wt%, the insertion loss (I. L.) can be reduced to 0.08 dB or less. A range for 1.0 to 4.0 wt% is particularly preferred.

### (Third Example)

In the same manner as in the first example, a garnet film having a main ingredient ratio of Gd_{1.1}Yb_{0.4}Bi_{1.5}Fe_{4.4}Al_{0.8}O₁₂ and containing about 0.7 wt% of B₂O₃ was grown to a thickness of about 500 µm.

Then, the specimen were kept at each of temperatures of 950°C, 1000°C, 1050°C, 1100°C, 1130°C and 1150°C for 10 hours to apply heat treatment.

After polishing both surfaces of the specimens to adjust the thickness such that the Faraday rotation angle at a wavelength of 1.55 µm was about 45 deg, measurement was conducted.

As a result, Hs was about 2.3873·10⁴ A/m (300 Oe), θ_{F} was about 1400 deg/cm, θ_{F/T} was about 0.05 deg/°C and T_{comp} was -40°C or lower for all specimens.

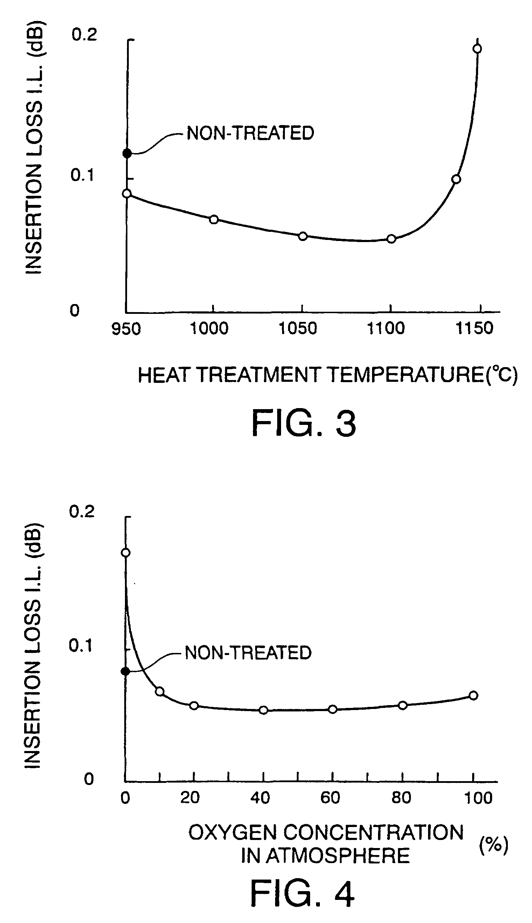

Further, the relation between the insertion loss (I. L.) and the heat treatment temperature is as shown in Fig. 3.

From Fig. 3, the effect of reducing the insertion loss (I. L.) is observed by the heat treatment within the range of heat temperature from 950 to 1140°C. Accordingly, it can be said that the heat treatment within a temperature range from 950 to 1140°C can be said to be useful.

### (Fourth Example)

In the same manner as in the first example, a garnet film having a main ingredient ratio of Gd_{2.0}Yb_{0.1}Bi_{0.9}Fe_{4.8}Al_{0.2}O₁₂ and containing B₂O₃ by about 0.5 wt% and PbO by about 1.5 wt% was grown to a thickness of about 700 µm.

Then, the specimens were heat treated at a temperature of 1050°C and an oxygen concentration in the atmosphere of 0, 10, 20, 40, 60, 80 and 100% and keeping for 20 hours, specimens were prepared and characteristics were measured.

As a result, Hs was about 3.9789·10⁴ A/m (500 Oe), θ_{F} was about 900 deg/cm, θ_{F} was about 0.07 deg/°C and T_{comp} was -40°C or lower.

Further, the relation between the insertion loss (I. L.) and the oxygen concentration in the heat treatment temperature is as shown in Fig. 4.

From Fig. 4, the effect of reducing the insertion loss (I. L.) by the heat treatment can be recognized within a range of the oxygen concentration in the heat treatment temperature atmosphere from 10 to 100%. Accordingly, it can be said that 10 to 100% of oxygen concentration in the heat treatment atmosphere can be said to be useful.

### (Fifth Example)

In the same manner as in the first example, garnet films containing about 0.5 wt% of B₂O₃ and about 1 wt% of PbO and with the main ingredient ratio of: Gd_{1.7}Yb_{0.2}Bi_{1.1}Fe_{5-z}Al_{z}O₁₂ in which z = 0.1, 0.2. 0.3, 0.4, 0.5, 0.6 and 0.7 were grown to a thickness of about 600 µm, specimens were prepared and characteristics were measured.

As a result, θ_{F} was about 1100 deg/cm and T_{comp} was -40°C for all specimens.

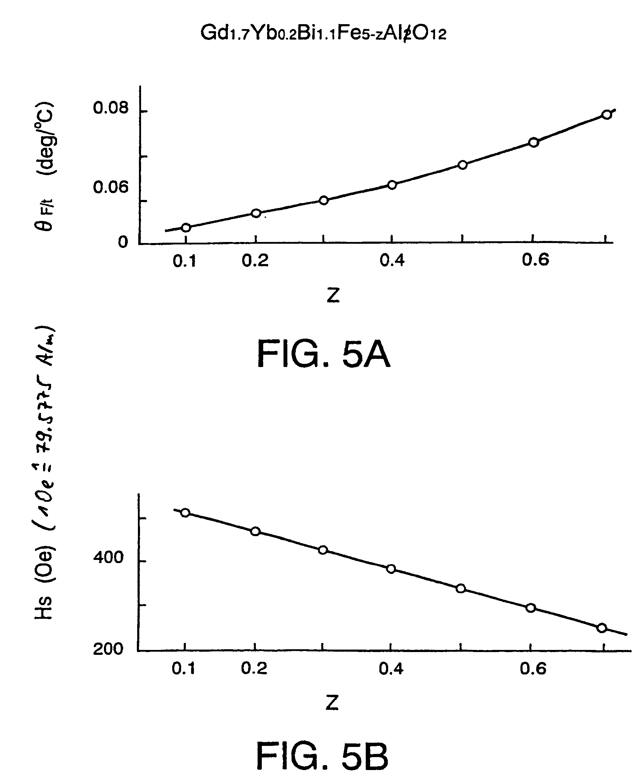

Relations between θ_{F/T}, and Hs and z are shown, respectively, in Fig. 5A and Fig. 5B.

Hs of 3.9789·10⁴ A/m (500 Oe) or less and θ_{F/T} of 0.08 deg/°C or lower were obtained within the range of z from 0.15 to 0.65.

### (Sixth Example)

In the same manner as in the first example, garnet films containing about 0.5 wt% of B₂O₃ and about 11 wt% of PbO and with the main ingredient ratio of: Gd_{1.9-x}YbₓBi_{1.1}Fe_{4.6}Al_{0.4}O₁₂ in which x = 0, 0.1, 0.2. 0.3, 0.4, 0.5 and 0.6 were grown to a thickness of about 600 µm, specimens were prepared and characteristics were measured.

As a result, θ_{F} was about 1100 deg/cm and T_{comp} was -40°C or less for all specimens.

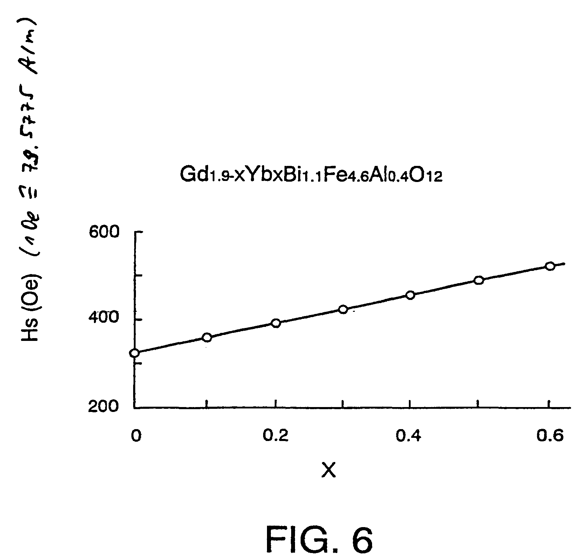

Relation between Hs and x is shown in Fig. 6. Hs of 3.9789·10⁴ A/m (500 Oe) or less was obtained for the range of x from 0 to 0.5.

### (Seventh Example)

In the same manner as in the first example, garnet films containing about 0.5 wt% of B₂O₃ and about 1 wt% of PbO and with the main ingredient ratio of (Gd_{1.7}Yb_{0.2})_{(3-y)}/_{1.9}Bi_{y}Fe_{4.6}Al_{0.4}O₁₂ in which y = 0.8, 0.9, 1.0, 1.1, 1.2, 1.3, 1.4, 1.5 and 1.6 were grown to a thickness of about 600 µm, specimens were prepared and characteristics were measured.

As a result, T_{comp} was -40°C or less and θ_{F/T} was from 0.06 to 0.076 deg/°C.

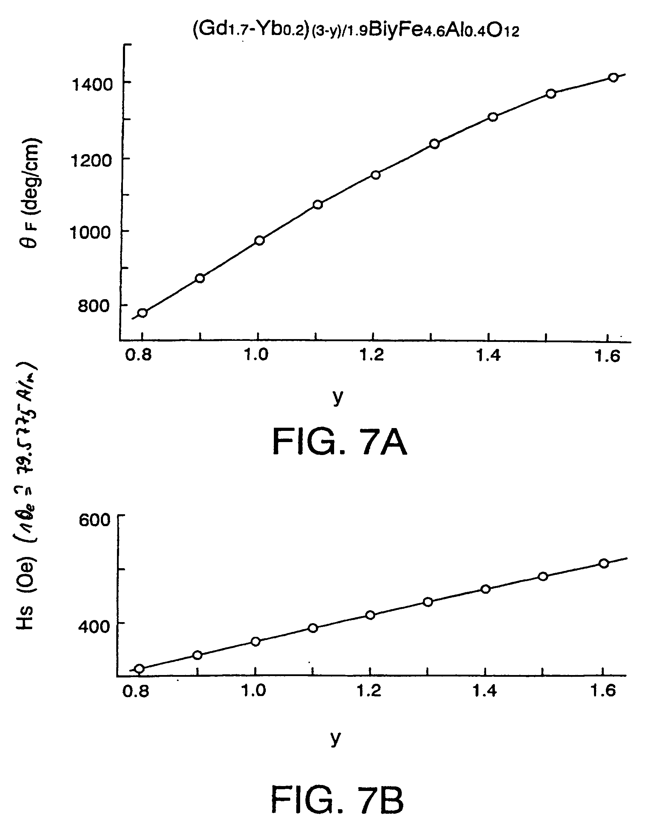

Relations between the obtained θ_{F}, and Hs and y are shown, respectively, in Fig. 7A and Fig. 7B.

θ_{F} of 800 deg/cm or more and Hs of 3.9789·10⁴ A/m (500 Oe or less) were obtained for the range of y from 0.85 to 1.55.

As has been described above, according to this invention, absorption at a wavelength of about 1.6 µm or more inherent to the TbBi series garnet is avoided and it can provide a material for a bismuth substituted garnet thick film improved with the temperature variation coefficient or the Faraday rotation effect of the GdYbBi series garnet, as well as a manufacturing method thereof.

Further, according to this invention, a Faraday rotation device to be used in a wavelength region in excess of about 1.5 µm can be provided.

## Claims

1. A material for a bismuth substituted garnet thick film comprising Yb, Bi, Fe and Al as the main ingredient grown by a liquid phase growing method on a garnet substrate in which the composition of the garnet thick film is represented by the general formula:
Gd_{3-x-y}YbₓBi_{y}Fe_{5-z}Al_{z}O₁₂
(0 < x ≤ 0.5, 0.85 ≤ y ≤ 1.55 and 0.15 ≤ z ≤ 0.65), and each of boron oxide (B₂O₃) and lead oxide (PbO) is contained by from 0 to 4.0 wt% (not including 0) in the garnet thick film.

2. A material for bismuth substituted garnet thick film as defined in claim 1, wherein the garnet thick film is applied with a heat treatment of keeping the garnet thick film at a temperature within a range from 950 to 1140°C.

3. A Faraday rotation device substantially comprising a garnet thick film comprising Gd, Yb, Bi, Fe and Al as the main ingredient grown by a liquid phase growing method on a garnet substrate, wherein the composition of the garnet thick film is represented by the general formula:
Gd_{3-x-y}YbₓBi_{y}Fe_{5-z}Al_{z}O₁₂
(0 < x ≤ 0.5, 0.85 ≤ y ≤ 1.55 and 0.15 ≤ z ≤ 0.65), and each of boron oxide (B₂O₃) and lead oxide (PbO) is contained by from 0 to 4.0 wt% (not including 0) in the garnet thick film.

4. A Faraday rotation device as defined in claim 3, wherein the garnet thick film is applied with a heat treatment of keeping the garnet thick film at a temperature within a range from 950 to 1140°C.

5. A method of manufacturing a material for bismuth substituted garnet thick film of growing a garnet thick film comprising Gd, Yb, Bi, Fe and Al by a liquid phase growing method on a garnet substrate, wherein the method includes growing the garnet thick film on a substituted gadolinium - gallium - garnet (SGGG) substrate and the composition of the garnet thick film is represented by the general formula:
Gd_{3-x-y}YbₓBi_{y}Fe_{5-z}Al_{z}O₁₂
(0 < x ≤ 0.5, 0.85 ≤ y ≤ 1.55 and 0.15 ≤ z ≤ 0.65), and each of boron oxide (B₂O₃) and lead oxide (PbO) is contained by from 0 to 4.0 wt% (not including 0) in the garnet thick film.

6. A method of manufacturing a material for a bismuth substituted garnet thick film as defined in claim 5, which further comprises a step of applying a heat treatment of keeping the garnet thick film at a temperature within a range from 950 to 1140°C.

7. A method of manufacturing material for a bismuth substituted garnet thick film as defined in claim 6, wherein the oxygen content in the atmospheric in the heat treatment is within a range from 10 to 100%.

## Patentansprüche

1. Material für einen Bismuth-substituierten Granat-Dickfilm, umfassend Yb, Bi, Fe und Al als dem Hauptbestandteil, der durch eine Flüssigphasen-Wachstumsmethode auf einem Granatsubstrat wachsen gelassen wurde, wobei die Zusammensetzung des Granat-Dickfilms durch die allgemeine Formel wiedergegeben ist:
Gd_{3-x-y}YbₓBi_{y}Fe_{5-z}Al_{z}O₁₂
(0 < x ≤ 0,5, 0,85 ≤ y ≤ 1,55 und 0,15 ≤ z ≤ 0,65), und wobei Boroxid (B₂O₃) und Bleioxid (PbO) jeweils mit 0 bis 4,0 Gew.-% (0 nicht einschließend) im Granat-Dickfilm enthalten ist.

2. Material für einen Bismuth-substituierten Granat-Dickfilm wie im Anspruch 1 definiert, wobei auf den Granat-Dickfilm eine Hitzebehandlung angewandt wurde, den Granat-Dickfilm bei einer Temperatur in einem Bereich von 950 bis 1.140°C zu halten.

3. Faraday'sche Rotationsvorrichtung, die im wesentlichen einen Granat-Dickfilm, umfassend Gd, Yb, Bi, Fe und Al als dem Hauptbestandteil, umfaßt, der durch eine Flüssigphasen-Wachstumsmethode auf einem Granatsubstrat wachsen gelassen wurde, wobei die Zusammensetzung des Granat-Dickfilms durch die allgemeine Formel wiedergegeben ist:
Gd_{3-x-y}YbₓBi_{y}Fe_{5-z}Al_{z}O₁₂
(0 < x ≤ 0,5, 0,85 ≤ y ≤ 1,55 und 0,15 ≤ z ≤ 0,65), und wobei Boroxid (B₂O₃) und Bleioxid (PbO) jeweils mit 0 bis 4,0 Gew.-% (0 nicht einschließend) im Granat-Dickfilm enthalten ist.

4. Faraday'sche Rotationsvorrichtung wie im Anspruch 3 definiert, wobei auf den Granat-Dickfilm eine Hitzebehandlung angewandt wurde, den Granat-Dickfilm bei einer Temperatur in einem Bereich von 950 bis 1.140°C zu halten.

5. Verfahren zur Herstellung eines Materials für einen Bismuth-substituierten Granat-Dickfilm mit dem Wachstum eines Granat-Dickfilms, der Gd, Yb, Bi, Fe und Al umfaßt, durch eine Flüssigphasen-Wachstumsmethode auf einem Granatsubstrat, wobei das Verfahren das Wachstum des Granat-Dickfilms auf einem substituierten Gadolinum-Gallium-Granat(SGGG)-Substrat einschließt und die Zusammensetzung des Granat-Dickfilms durch die allgemeine Formel wiedergegeben ist:
Gd_{3-x-y}YbₓBi_{y}Fe_{5-z}Al_{z}O₁₂
(0 < x ≤ 0,5, 0,85 ≤ y ≤ 1,55 und 0,15 ≤ z ≤ 0,65), und wobei Boroxid (B₂O₃) und Bleioxid (PbO) jeweils mit 0 bis 4,0 Gew.-% (0 nicht einschließend) im Granat-Dickfilm enthalten ist.

6. Verfahren zur Herstellung eines Materials für einen Bismuth-substituierten Granat-Dickfilm wie im Anspruch 5 definiert, ferner mit einem Schritt des Anwendens einer Hitzebehandlung, den Granat-Dickfilm bei einer Temperatur in einem Bereich von 950 bis 1.140°C zu halten.

7. Verfahren zur Herstellung eines Materials für einen Bismuth-substituierten Granat-Dickfilm wie im Anspruch 6 definiert, wobei der Sauerstoffgehalt in der Atmosphäre der Hitzebehandlung in einem Bereich von 10 bis 100% liegt.

## Revendications

1. Matériau pour film épais de grenat substitué par du bismuth, comprenant comme ingrédient principal les métaux Yb. Bi, Fe et Al, développé sur un substrat de grenat suivant un procédé de croissance en phase liquide, la composition du film étant représentée par la formule générale :
Gd_{3-x-y}YbₓBi_{y}Fe₅₋ₓAl_{z}O₁₂
(0 < x ≤ 0,5 ; 0,85 ≤ y ≤ 1,55 et 0,15 ≤ z ≤ 0,65), et chacun de l'oxyde de bore (B₂O₃) et l'oxyde de plomb (PbO) étant également contenu en proportion de 0 à 4,0 % en poids (0 non inclus) dans le film.

2. Matériau pour film épais de grenat substitué par du bismuth selon la revendication 1,
**caractérisé en ce que**
le film est appliqué à l'aide d'un traitement thermique qui le maintient à une température comprise entre 950 et 1140°C.

3. Dispositif de rotation de Faraday contenant essentiellement un film épais de grenat, comprenant comme ingrédient principal les métaux Gd, Yb, Bi. Fe et Al, développé sur un substrat de grenat suivant un procédé de croissance en phase liquide, la composition du film étant représentée par la formule générale :
Gd_{3-x-y}YbₓBl_{y}Fe₅₋ₓAl_{z}O₁₂
(0 < x ≤ 0,5 ; 0,85 ≤ y ≤ 1,55 et 0,15 ≤ z ≤ 0,65), et chacun de l'oxyde de bore (B₂O₃) et l'oxyde de plomb (PbO) étant également contenu en proportion de 0 à 4,0 % en poids (0 non inclus) dans le film.

4. Dispositif de rotation de Faraday selon la revendication 3,
**caractérisé en ce que**
le film est appliqué à l'aide d'un traitement thermique qui le maintient à une température comprise entre 950 et 1140°C.

5. Procédé de fabrication d'un matériau pour film épais de grenat substitué par du bismuth, qui consiste à développer le film comprenant les métaux Gd, Yb, Bi, Fe et Al sur un substrat de métal, suivant un procédé de croissance en phase liquide, lequel procédé inclut le développement du film sur un substrat substitué de gadolinium/gallium/grenat (SGGG), la composition générale du film épais de grenat étant représentée par la formule :
Gd_{3-x-y}YbₓBi_{y}Fe₅₋ₓAl_{z}O₁₂
(0 < x ≤ 0,5 ; 0,85 ≤ y ≤ 1,55 et 0,15 ≤ z ≤ 0,65), et chacun de l'oxyde de bore (B₂O₃) et l'oxyde de plomb (PbO) étant également contenu en proportion de 0 à 4,0 % en poids (0 non inclus) dans le film.

6. Procédé de fabrication d'un matériau pour film épais de grenat substitué par du bismuth selon la revendication 5,
**caractérisé par**
en outre une étape consistant à appliquer un traitement thermique maintenant le film à une température comprise entre 950 et 1140°C.

7. Procédé de fabrication d'un matériau pour film épais de grenat substitué par du bismuth selon dans la revendication 6,
**caractérisé en ce que**
la teneur de l'atmosphère en oxygène, intervenant dans le traitement thermique, est comprise entre 10 et 100 %.
